# EUROPÄISCHE PATENTANMELDUNG

(11) **EP 1 351 299 A2**
(43) Veröffentlichungstag der Anmeldung: **08.10.2003**
(21) Anmeldenummer: 03006001.6
(22) Anmeldetag: 18.03.2003
(51) Int. Cl.: H01L 23/538

(54) **Flexibler dünner Schaltungsaufbau**

(30) Priorität: 04.04.2002 DE 10214847
(71) Anmelder: Diehl Munitionssysteme GmbH & Co. KG, 90552 Röthenbach (DE)
(72) Erfinder: Danzer, Ludwig, 90530 Wendelstein (DE)
(74) Vertreter: Diehl Patentabteilung

(57) **Zusammenfassung**

Um die mechanischen Eigenschaften von Polymerschaltungen mit den datenverarbeitungstechnischen Eigenschaften hochintegrierter Silizium-Schaltkreise (11) zu verknüpfen, werden die elektrisch inerten Siliziumblöcke der Schaltkreise (11) deren Diffusionszonen gegenüber mechanisch bis auf eine biegefähige Restdicke gedünnt und sandwichartig in einen Polymerträger (13) eingebracht. In dem erfolgt eine Auffächerung der Bondanschlüsse (18) längs der eingebetteten Schaltkreise (11) zu vergrößerten Anschlußflächen (20) auf der Oberfläche dieser Schaltkreise (11), um von hier aus mittels Durchstiegen (14) eine elektrische Verbindung zur Montagefläche (15) des Polymerträgers (13) herzustellen, auf der herkömmliche Bauelemente (17) in Form von aktiven und passiven diskreten oder integrierten Schaltungsbestandteilen kontaktiert sind. Dieser flexible Multichip-Modul kann dann mittels Lötkugeln (21) auf einen herkömmlichen Verdrahtungsträger (22) appliziert werden.

## Beschreibung

Die Erfindung betrifft einen Schaltungsaufbau gemäß dem Oberbegriff des Anspruches 1.

Etwa für räumlich beengte Einbauumgebungen ist es bekannt, keine starren Verdrahtungsplatinen für gedruckte Leiterbahnen einzusetzen, sondern flexible Verdrahtungsträger. Deren Verwendung weist auch die Vorteile auf, resistenter gegen Bruchgefahren aus mechanischen Schockbeanspruchungen zu sein und thermische Beanspruchungen mit der Folge geringfügiger Verformung der dreidimensionalen Einbaugeometrie problemlos aufnehmen zu können. Der praktische Einsatz solcher flexibler Schaltungen ist allerdings in der Praxis im wesentlichen auf Verdrahtungsverbindungen zwischen starren gedruckten Platinen beschränkt, die ihrerseits Bauelemente und Schaltkreise aufnehmen. Eine unmittelbare Bestückung flexibler Verdrahtungsträger mit diskreten Bauelementen und integrierten Schaltkreisen - zumal in Oberflächen-Montagetechnik (SMD) - würde an den Bestükkungsrändern infolge des Übergangs vom starren Element zum flexiblen Träger Knickstellen und damit Bruchstellen oder gar schwer auffindbare Haarrisse hervorrufen.

Solche Gefährdungen bestehen nicht, wenn gemäß dem Beitrag in ELEKTRONIK, Heft 15/2001, Seite 20 "Polymer-ICs aus Erlangen" flexible Schaltungen mit elektronischen Strukturen auf Polymerbasis Anwendung finden. Allerdings ist wie dort dargelegt in absehbarer Zeit nur in sehr speziellen Fällen ein Einsatz solcher Strukturen zu erwarten, da an die keine hohen Anforderungen hinsichtlich der Kapazität der Datenverarbeitung gestellt werden können. Die in jener Technologie erstellten Polymertransistoren dürften kaum die Leistungsfähigkeit von Siliziumschaltkreisen erreichen.

Der Erfindung liegt die Aufgabe zugrunde, zwischen diesen Technologien einen Kompromiß aufzuzeigen, der - trotz Rückgriffs auf die bewährte Siliziumtechnologie für integrierte Schaltkreise auch höchster Komplexität - doch zu einem dünnen und flexiblen Aufbau von Multilayerstrukturen führt.

Diese Aufgabe ist erfindungsgemäß durch die im Hauptanspruch angegebenen Kombination der wesentlichen Merkmale gelöst. Danach wird der Siliziumblock eines herkömmlichen integrierten Schaltkreises auf seiner der eindiffundierten Schaltungsstruktur gegenüberliegenden Rückseite bis auf etwa 10 % seiner ursprünglichen Dicke mechanisch verdünnt, insbesondere abgeschliffen, so daß gerade noch genügend Struktur für die Aufrechterhaltung der Schaltungsfunktion verbleibt. Der so nachträglich bis zur Biegsamkeit mechanisch gedünnte Siliziumschaltkreis wird sandwichähnlich in das Innere einer weichen Polymer-Trägerschicht eingebracht. Diese dient auf einer Oberfläche (nachstehend auch als Montagefläche bezeichnet) der Aufnahme und Verdrahtung herkömmlicher, beispielsweise gehäuster Schaltkreise (Chips) und deren Verdrahtung untereinander sowie zu den eingebetteten dünnen Chips hin. An der gegenüberliegenden Oberfläche eines solchen flexiblen Multichipmodules können an dessen Verschaltung angeschlossene punktuelle Lotverbindungen zu einem herkömmlichen Verdrahtungsträger hergestellt werden.

Eine zuverlässige elektrische Verbindung vor allem von den Bondanschlüssen des jeweiligen, in das Polymer eingelagerten gedünnten Schaltkreises zu den auf der Oberfläche des Polymerträgers montierten herkömmlich belassenen Schaltkreisen wird gefördert, wenn die längs des Chiprandes eng beieinanderliegenden kleinflächigen Anschlüsse des jeweiligen in den Polymerträger eingebetteten Schaltkreises zu Durchstiegspositionen auf dessen elektrisch isolierter Oberfläche hin aufgefächert werden.

Zusätzliche Merkmale, Alternativen und Weiterbildungen zur erfindungsgemäßen Lösung ergeben sich aus den weiteren Ansprüchen und aus nachstehender Beschreibung eines in der Zeichnung unter Beschränkung auf das Wesentliche nicht maßstabsgerecht skizzierten bevorzugten Realisierungsbeispiels zum erfindungsgemäßen Schaltungsaufbau.

In der Zeichnung zeigt:
- Fig. 1: In abgebrochener Querschnittsdarstellung die Verdrahtung von in einen Polymerträger eingebetteten gedünnten Silizium-Schaltkreisen und
- Fig. 2: einen Blick auf die Anschluß-Auffächerung eines ins Polymer eingebetteten gedünnten Schaltkreises in gegenüber Fig. 1 vergrößertem Maßstab bei ebenfalls abgebrochener Darstellung.

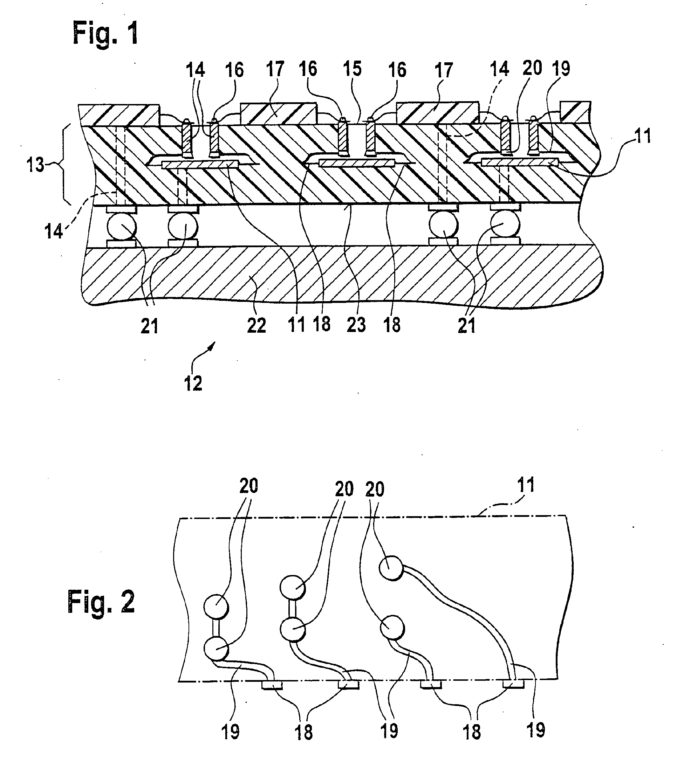

Die Zeichnung zeigt beispielhaft und nicht maßstabsgerecht auf das Wesentliche abstrahiert die Integration mechanisch gedünnter integrierter Schaltkreise 11 (Chips) zu einer flexiblen Multilayer-Struktur. Der diesbezüglich in Fig. 1 in abgebrochener Querschnittsdarstellung skizzierte Schaltungsaufbau 12 weist einen - gegebenenfalls auch mehrlagigen - Polymerträger 13 von typisch etwa 1 mm Stärke auf, in den die Schaltkreise 11 etwa mittig eingebettet sind. Da die elektrische Funktion eines solchen üblicherweise in einen Silizium-Einkristall eindiffundierten Schaltkreises sich im µ-Bereich dicht unter der Diffüsionsoberfläche abspielt, kann ein solcher Schaltkreis ohne Beeinträchtigung seiner Funktion gegenüberliegend ohne weiteres bis auf etwa 10 % seiner ursprünglich typisch 0,5 mm Stärke mechanisch oder chemisch abgearbeitet werden. Der so gedünnte Schaltkreis 11 ist also noch voll funktionsfähig, aber und gegenüber der ursprünglichen Struktur nun auch flexibel. Er schmiegt sich deshalb ohne besonders aufzutragen einer mechanischen Biegeverformung des Polymerträgers 13 an.

Über in den Polymerträger 13 quer zu seiner Flächenausdehnung eingebrachte Durchstiege 14 ist jeder eingebettete gedünnte Schaltkreis 11 elektrisch leitend mit der Trägerfläche 15 des Polymerträgers 13 verbunden. Auf dieser Trägerfläche 15, also an den freiliegenden Enden der Durchstiege 14, sind Lötpunkte 16 für den Anschluß von Bauelementen 17 vorgesehen. Bei diesen kann es sich um diskrete aktive und passive elektrische Bauelemente handeln; aber auch um ungehäuste (und nicht-verdünnte) Chips, deren Pads mit Bonddrähten an die Lötpunkte 16 angeschlossen sind; bzw. um gehäuste Schaltkreise, die mit ihren Lötfahnen (Pins) an die Lötpunkte 16 angeschlossen sind.

Die Bondanschlüsse (Pads) auch an den eingebetteten, gedünnten Schaltkreisen 11 sind derart klein und einander dicht benachbart, daß eine zuverlässige und querschlußfreie elektrische Kontaktierung über die Durchstiege 14 vergleichsweise großen Durchmessers unmittelbar daran problematisch ist. Deshalb sind diese Bondanschlüsse 18 der Diffüsionsseite gegenüberliegend über die Grundfläche des jeweiligen eingebetteten Schaltkreises 11 aufgefächert. Dabei führen geschwungen verlaufende Anschlußleiter 19 zu Anschlußflächen 20 auf der elektrisch neutralen, mechanisch bearbeiteten Rückseite des Siliziumgrundkörpers des Schaltkreises 11. Nur zur Verdeutlichung der Darstellung verlaufen die Anschlußleiter 19 in Fig. 1 distanziert oberhalb des Schaltkreises 11, tatsächlich fächern sie sich unmittelbar auf seiner Rückseite auf. Der Durchmesser der Anschlußlächen 20 ist wenigstens gleich dem der Durchstiege 14. Der geschwungene Verlauf der Anschlußleiter 19 erbringt eine hinreichende Elastizität gegen die Gefahr von Leiterbruch bei Biegebeanspruchung des Polymerträgers 13.

Weitere Durchstiege 14 führen von der Montagefläche 15 des Polymerträgers 13 aus durch diesen hindurch, an den eingebetteten Schaltkreisen 11 seitlich vorbei, zu Anschlußflächen 20 auf der Unterseite 23 des Polymerträgers 13, um hier mittels Lotkugeln 21 auf einen herkömmlichen Verdrahtungsträger 22 appliziert werden zu können.

Um die mechanischen Eigenschaften von Polymerschaltungen mit den datenverarbeitungstechnischen Eigenschaften hochintegrierter Silizium-Schaltkreise 11 zu vereinen, werden also erfindungsgemäß die elektrisch inerten Siliziumblöcke der Schaltkreise 11 deren Diffusionszonen gegenüber mechanisch bis auf eine biegefähige Restdicke abgenommen und die so gedünnten Schaltkreise 11 sandwichartig in einen Polymerträger 13 eingebracht. In dem erfolgt eine Auffächerung der Bondanschlüsse 18 längs der eingebetteten Schaltkreise 11 zu vergrößerten Anschlußflächen 20 auf der elektrisch isolierenden Oberfläche dieser Schaltkreise 11, um von hier aus mittels Durchstiegen 14 eine elektrische Verbindung zur Montagefläche 15 des Polymerträgers 13 herzustellen, auf der herkömmliche Bauelemente 17 in Form von aktiven und passiven diskreten oder integrierten Schaltungsbestandteilen kontaktiert sind. Dieser flexible Multichip-Modul kann dann mittels Lötkugeln 21 auf einen herkömmlichen Verdrahtungsträger 22 appliziert werden.

## Patentansprüche

1. Flexibler dünner Schaltungsaufbau (12),
**dadurch gekennzeichnet,**
**daß** gedünnte, integrierte Schaltkreise (11) in einen Polymerträger (13) eingebettet sind.

2. Schaltungsaufbau nach Anspruch 1,
**dadurch gekennzeichnet,**
**daß** Bondanschlüsse (18) an den Rändern des gedünnten Schaltkreises (11) über geschwungen verlaufende Anschlußleiter (19) zu vergrößerten Anschlußflächen (20) aufgefächert sind, über die Fläche des Schaltkreises (11) verteilt sind.

3. Schaltungsaufbau nach Anspruch 1 oder 2,
**dadurch gekennzeichnet,**
**daß** der Polymerträger (13) als Schaltungsträger für konventionelle Bauelemente (17) in Form von diskreten Bauteilen oder ungedünnten integrierten Schaltkreisen dient.

4. Schaltungsaufbau nach Anspruch 3,
**dadurch gekennzeichnet,**
**daß** die Bauelemente (17) über Durchstiege (14) im Polymerträger (13) an die eingebetteten gedünnten Schaltkreise (11) elektrisch angeschlossen sind.

5. Schaltungsaufbau nach einem der vorangehenden Ansprüche,
**dadurch gekennzeichnet,**
**daß** der Polymerträger (13) mit Lotkugeln (21) auf seiner Unterseite (23) auf einen herkömmlichen Verdrahtungsträger (22) aufgebracht ist.

6. Schaltungsaufbau nach Anspruch 5,
**dadurch gekennzeichnet,**
**daß** die Lotkugeln (21) mittels Durchstiegen (14) zu Lötpunkten (16) auf der Montagefläche (15) des Polymerträgers (13) durchkontaktiert sind.
